# EUROPEAN PATENT APPLICATION

(11) **EP 3 737 215 A1**
(43) Date of publication of application: **11.11.2020**
(21) Application number: 19177862.0
(22) Date of filing: 03.06.2019
(51) Int. Cl.: H05K 3/36, H01R 12/58, H05K 3/32

(54) **METHOD FOR CONNECTING A CONNECTOR PIN TO A PRINTED CIRCUIT BOARD**

(30) Priority: 10.05.2019 US 201962845905 P
(71) Applicant: BIOTRONIK SE & Co. KG, 12359 Berlin (DE)
(72) Inventor: Primavera, Anthony A., Newberg, OR Oregon 97132 (US); Green, Donna, Sherwood, OR Oregon 97140 (US)
(74) Representative: Keck, Hans-Georg

(57) **Abstract**

In a method for connecting a connector pin (2) to a printed circuit board (1) a printed circuit board (1) having a dielectric body (10) and a conductive layer (11, 16) is provided, wherein a via hole (100) is formed in the dielectric body (10). A basket device (3) having a body portion (31) is placed on the printed circuit board (10) such the basket device (3) electrically contacts the conductive layer (11, 16) and reaches, with said body portion (31), into the via hole (100) formed in the di-electric body (10) of the printed circuit board (1). A connector pin (2) having a shaft portion (21) is placed on the basket device (3) such that the shaft portion (21) reaches into said via hole (100) and the basket de-vice (3) interacts with the connector pin (2) for retaining the connector pin (2) on the printed circuit board (1).

## Description

The instant invention generally relates to a method for connecting a connector pin to a printed circuit board and to a printed circuit board assembly.

Printed circuit boards - as they are used in electronic devices for example in the medical field, for example in implantable devices such as pacemaker devices or stimulation devices for pacing or stimulating heart activity, but also outside of the medical field for example in smart phones or the like - require the connection of components to mechanically fix and electrically contact components to circuit structures provided on or in the printed circuit board. The connection of components to the circuit board herein generally takes place by soldering, wherein typically for example solder may be deposited onto surface contact pads of printed circuit boards and components may be placed on top of the solder deposit in order to provide for a soldering in a mass reflow oven at a temperature that is above the melting point of the solder, typically at 230-250°C. Such soldering techniques generally hence cause a heating up of the printed circuit board and the components placed thereon, which one may wish to avoid in particular for components - such as telemetry coils - which are heat sensitive and which may deform when subjected to heat, hence causing a warpage possibly leading to a yield loss and an increase in costs due to scrap or a necessity for rework.

There hence is a desire to provide for a technique allowing to reliably connect a connector pin to a printed circuit board while reducing an impact of heat on the printed circuit board and components placed thereon.

Document US 4,970,624 discloses an electronic device which includes a circuit sheet having a contact path thereon. Adhesive is deposited on the conductive path, the adhesive including a nonconductive base incorporating randomly spaced conductive particles. A circuit component is forced through the adhesive, the conductive path and the circuit sheet carrying a portion of the adhesive therewith between the circuit component and the conductive path.

Document US 4,598,470 discloses a method of making an aperture of a predetermined shape into a dielectric substrate which will lockingly receive a deformable contact pin.

It is an object of the present disclosure to provide a method and a printed circuit board assembly which allow for a connection of a connector pin to a printed circuit board while reducing an impact of heat on the printed circuit board and components placed thereon.

This object is addressed by a method for connecting a connector pin to a printed circuit board, the method comprising: providing a printed circuit board having a dielectric body and a conductive layer, wherein a via hole is formed in the dielectric body; placing a basket device having a body portion on the printed circuit board such that the basket device electrically contacts the conductive layer and reaches, with said body portion, into the via hole formed in the dielectric body of the printed circuit board; and placing a connector pin having a shaft portion on the basket device such that the shaft portion reaches into said via hole and the basket device interacts with the connector pin for retaining the connector pin on the printed circuit board.

A connector pin may, in one embodiment, serve to connect an electrical or electronic component to the printed circuit board. The connector pin may herein form part of the electrical or electronic component, such that the electrical or electronic component may be inserted, by means of the connector pin protruding from a body of the electrical or electronic component, into the basket device and in this way may be connected to the printed circuit board. The connector pin may alternatively be connected to a conductor, such as a flexible conductor, for example a flexible printed circuit board, e.g. a so-called rigid-flex PCB. The connector pin generally serves to provide for an electrical connection to the printed circuit board, in particular to a conductive path formed by a conductive layer of the printed circuit board.

Within the method a printed circuit board is provided which comprises a dielectric body and a via hole formed in the dielectric body. For placing the connector pin on the printed circuit board, an electrically conductive basket device is placed on the printed circuit board such that a body portion of the basket device comes to rest in the via hole of the dielectric body. The basket device herein electrically contacts the conductive layer of the printed circuit board such that by means of the basket device an electrical connection to the conductive layer may be established.

The connection of the connector pin to the printed circuit board takes place by placing the connector pin on the basket device such that a shaft portion of the connector pin engages the basket device and reaches into the via hole formed in the dielectric body of the printed circuit board. The basket device herein, when the connector pin is received on the basket device, interacts with the connector pin such that the connector pin is retained on the printed circuit board and hence is mechanically held on the printed circuit board by means of the basket device.

The basket device, in one embodiment, is placed on the printed circuit board prior to placing the connector pin on the basket device. The basket device herein is fixed to the printed circuit board, for example by means of a press-fit connection or by forming a solder connection in between the basket device and the printed circuit board. In one example, the basket device is press-fitted to the printed circuit board such that the basket device is fixed to the printed circuit board in a force-fitting manner. In another example a solder connection is formed in between the basket device and the printed circuit board upon placing the basket device on the printed circuit board, such that the basket device is mechanically fixed to the printed circuit board and at the same time is electrically connected to the conductive layer formed on the dielectric body of the printed circuit board.

In one embodiment, the method comprises the additional step of fixing the connector pin to the printed circuit board by forming a solder connection in the via hole. After placing the connector pin on the basket device the connector pin hence is additionally fixed to the printed circuit board and the basket device, wherein in addition by means of the solder connection a low-resistance electrical connection in between the connector pin and the basket device and via the basket device to the printed circuit board is formed.

For forming the solder connection in between the connector pin and the basket device in the via hole a solder technique may be employed which causes only a local heating at the connector pin, but reduces a heat impact at other regions of the printed circuit board. In particular, for forming the solder connection a preform solder component, for example having the shape of a doughnut or the like, may be placed on the shaft portion of the connector pin within the via hole of the dielectric body of the printed circuit board, wherein for forming a solder connection the preform solder component is heated by using a suitable heat source, for example a laser heat source or the like.

The placement of the connector pin on the basket device may take place in a mounting direction such that the connector pin with its shaft portion comes to engage with the body portion of the basket device. For forming the solder connection the printed circuit board may be flipped over such that the soldering may take place in a reverse direction (from a backside of the printed circuit board) within the via hole, the connector pin being mechanically retained on the printed circuit board by means of the basket device for forming the solder connection.

In one embodiment, the body portion may have a cup shape circumferentially extending about the mounting direction along which the body portion reaches into the via hole upon placement of the basket device on the printed circuit board. The via hole generally extends through the body portion along the mounting direction. When placing the basket device on the printed circuit board the body portion comes to engage with the via hole such that the body portion reaches into the via hole along the mounting direction. The body portion herein circumferentially extends about the mounting direction and has a cup shape for receiving the shaft portion of the connector pin.

In one embodiment it is conceivable that cutouts are formed in the body portion, such that the body portion may locally be interrupted.

In one embodiment, the basket device comprises an upper portion for example in the shape of a circumferential rim and a lower portion at an end of the basket device opposite to the upper portion. The body portion herein extends in between the upper portion and the lower portion and hence connects the upper portion and the lower portion to each other. When the basket device is placed on the printed circuit board the body portion reaches into the via hole and the lower portion comes to rest within the via hole, the lower portion being shaped for example to mechanically retain the connector pin with respect to the printed circuit board upon placing the connector pin on the basket device. When inserting the shaft portion of the connector pin into the basket device, the shaft portion hence engages with the lower portion and interacts with the lower portion such that the shaft portion is mechanically retained within the via hole by means of the basket device.

By means of the upper portion the basket device may electrically contact the conductive layer of the circuit board and may be mechanically fixed to the printed circuit board. When the basket device is placed on the printed circuit board the upper portion may for example come to rest on a conductive layer formed on top of the printed circuit board such that the upper portion contacts the conductive layer. By forming a solder connection in between the upper portion and the conductive layer the basket device may be both mechanically fixed and electrically connected to the conductive layer of the printed circuit board.

In one embodiment, the lower portion of the basket device forms an opening into which the connector pin is inserted when placing the connector pin on the basket device. In a mounted state the connector pin, by means of its shaft portion, reaches through the opening of the lower portion of the basket device such that the connector pin reaches from one side of the basket device towards the other side and by means of its shaft portion comes to rest in the via hole formed in the dielectric body of the printed circuit board.

In one embodiment, the lower portion comprises a multiplicity of retaining elements shaped to mechanically interact with the shaft portion when inserting the shaft portion into said opening formed in the lower portion. The retaining elements may in particular be elastically deformable such that the retaining elements are deformed when inserting the shaft portion through the opening of the lower portion of the basket device. The retaining elements herein cooperate with the shaft portion to retain the shaft portion within the opening of the lower portion.

The retaining elements may have characteristics similar to a spring and may for example have the shape of wedges which with their tips point towards the opening formed in the lower portion. At their tips the retaining elements may have a pointed shape, a cut-off shape or a rounded shape, wherein an angle formed at the tip may differ from a wedge angle of the retaining element at a region distant from the tip. Neighboring retaining elements herein may be separated from each other by means of a slit formed in between the retaining elements, such that the retaining elements may be elastically deformed when inserting the shaft portion of the connector pin into the opening formed in the lower portion of the basket device.

The retaining elements may be formed on the lower portion of the basket device for example by mechanical milling using photolithography or by direct laser structuring. In particular, a laser may be used to cut the lower portion of the basket device in a desired shape.

In one embodiment, the connector pin comprises a head portion adjoining the shaft portion. When placing the connector pin on the basket device the head portion comes to rest at a first (outer) side of the basket device, whereas the shaft portion extends from the first side of the basket device through the opening formed in the lower portion of the basket device towards a second side of the basket device. Whereas the head portion of the connector pin hence may remain outside of the via hole formed in the dielectric body of the printed circuit board, the shaft portion of the connector pin reaches into the via hole, allowing to form a solder connection within the via hole in order to fix the connector pin with respect to the basket device and the printed circuit board after inserting the connector pin into the basket device.

The solder connection in between the connector pin and the basket device may in particular be formed on the second side of the basket device after placing the connector pin on the basket device. For this, a preform solder component for example in the shape of a doughnut may be placed on the shaft portion at the second side of the basket device, thus within the via hole formed in the dielectric body of the printed circuit board, such that a heat source, for example provided by a laser beam, may act onto the preform solder component in order to melt the preform solder component to form the solder connection on the second side of the basket device.

The object is also addressed by means of a printed circuit board assembly, comprising: a printed circuit board having a dielectric body and a conductive layer, wherein a via hole is formed in the dielectric body; a basket device having a body portion, wherein the basket device is placed on the printed circuit board such that the basket device electrically contacts the conductive layer and reaches, with said body portion, into the via hole formed in the dielectric body of the printed circuit board; and a connector pin having a shaft portion, wherein the connector pin is placed on the basket device such that the shaft portion reaches into said via hole and the basket device interacts with the connector pin for retaining the connector pin on the printed circuit board.

The advantages and advantageous embodiments described above for the method equally apply also to the printed circuit board assembly such that it shall be referred to the above.

The various features and advantages of the present invention may be more readily understood with reference to the following detailed description and the embodiments shown in the drawings. Herein,
- Fig. 1: shows a schematic drawing of a printed circuit board with a basket device and a connector pin placed thereon;
- Fig. 2: shows a schematic top view of a basket device placed on a printed circuit board;
- Fig. 3: shows a view of an example of a printed circuit board;
- Fig. 4A: shows a schematic drawing of a step of placing a basket device on a printed circuit board;
- Fig. 4B: shows a schematic drawing of the basket device in a state in which it is placed on the printed circuit board;
- Fig. 4C: shows a schematic drawing of a step of placing a connector pin on the basket device placed on the printed circuit board;
- Fig. 4D: shows a schematic drawing of the connector pin when placed on the basket device;
- Fig. 5A: shows a schematic drawing of a step of placing a connector pin on a basket device placed on a printed circuit board;
- Fig. 5B: shows a schematic drawing of the connector pin when placed on the basket device, prior to placing a preform solder component on a shaft portion of the connector pin for forming a solder connection;
- Fig. 5C: shows a schematic drawing of forming the solder connection by melting the preform solder component;
- Fig. 5D: shows a schematic drawing of the connection of the connector pin to the basket device and the printed circuit board after forming the solder connection;
- Fig. 6: shows a schematic view of a lower portion of the basket device having a retaining structure wall for retaining the connector pin;
- Fig. 7: shows a schematic drawing of another example of a retaining structure;
- Fig. 8: shows a schematic drawing of yet another example of a retaining structure;
- Fig. 9: shows a schematic drawing of yet another example of a retaining structure;
- Fig. 10A: shows a printed circuit board prior to forming a via hole;
- Fig. 10B: shows the printed circuit board, after forming the via hole;
- Fig. 10C: shows the printed circuit board, while placing a conductive layer on top of the printed circuit board by means of an adhesive layer;
- Fig. 10D: shows the printed circuit board with the conductive layer placed on top;
- Fig. 10E: shows the printed circuit board while forming a via from the conductive layer to another conductive layer of the printed circuit board located beneath;
- Fig. 10F: shows the printed circuit board with an electrical connection formed in between the conductive layer on top and the conductive layer beneath;
- Fig. 10G: shows the printed circuit board, with the conductive layer on top being structured for example by photolithography;
- Fig. 10H: shows the printed circuit board after a retaining structure is formed on the conductive layer on top;
- Fig. 11: shows a schematic drawing of an example of a retaining structure formed on a conductive layer;
- Fig. 12: shows a schematic drawing of another example of a retaining structure formed on a conductive layer;
- Fig. 13: shows a schematic drawing of yet another example of a retaining structure formed on a conductive layer;
- Fig. 14: shows a schematic drawing of yet another example of a retaining structure formed on a conductive layer;
- Fig. 15A: shows a schematic drawing of a printed circuit board while placing a connector pin on the printed circuit board;
- Fig. 15B: shows a schematic drawing of the printed circuit board prior to forming a soldering connection in between the connector pin and the printed circuit board;
- Fig. 15C: shows a schematic drawing of the printed circuit board while forming the solder connection; and
- Fig. 15D: shows a schematic drawing of the printed circuit board with a solder connection being formed in between the connector pin and the printed circuit board.

Subsequently, embodiments of the invention shall be described in detail with reference to the drawings. In the drawings, like reference numerals designate like structural elements.

It is to be noted that the embodiments are not limiting for the invention, but merely represent illustrative examples.

For example medical components require electrical or electronic components to be connected to a printed circuit board in order to form an electronic subassembly to be used for example in an implantable device such as a pacemaker device or a simulation device. As such components may be small in size and tiny in their structure, such components may be sensitive to heat, as they may be deformed when subjected to heat and may potentially be harmed in their function by an excessive heat impact.

As the connection of electrical components to a printed circuit board generally takes place by soldering, the aforementioned causes a desire for a soldering technique which may provide for a reduced heat impact and which may cause only a local heating of a printed circuit board assembly.

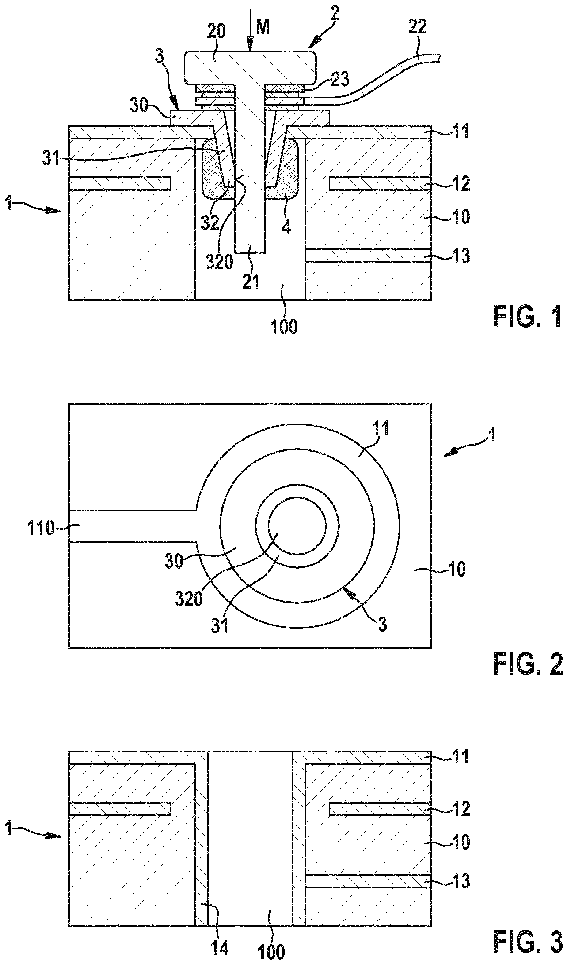

Referring now to Fig. 1, in an embodiment of a printed circuit board assembly a printed circuit board 1 comprises a dielectric body 10, a conductive layer 11 formed on top of the dielectric body 10 and inner conductive layers 12, 13 formed within the dielectric body 10. The conductive layers 11, 12, 13 may provide for circuit patterns 110 (see Fig. 2) to electrically connect components placed on the printed circuit board 1 to provide for a desired electronic function.

An electrical or electronic component is fixed to the printed circuit board 1, in the example of Fig. 1, by means of a connector pin 2 having a head portion 20 and a shaft portion 21 extending from the head portion 20. A component 22, for example formed by a flexible conductor, for example a flex PCB, is connected to the connector pin 2 for example by means of a fastening connection 23, for example a solder connection, such that the component 22 is mechanically fixed and at the same time is electrically connected to the connector pin 2.

The connector pin 2, in the embodiment of Fig. 1, is connected to the printed circuit board 1 by means of a basket device 3 placed on the printed circuit board 1, the basket device 3 having an upper portion 30 in the shape of a circumferential rim, as is apparent from Fig. 2, a lower portion 32 and a body portion 31 connecting the upper portion 30 and the lower portion 32 to each other. The basket device 3 is electrically conductive and for example formed from a gold-coated metal material. The basket device 3, with its upper portion 30, is placed on the upper conductive layer 11 and is fixed to the upper conductive layer 11 such that the basket device 3 is mechanically and electrically connected to the printed circuit board 1.

Within the dielectric body 10 of the printed circuit board 1 a via hole 100 is formed, the via hole 100 serving to receive the body portion 31 and the lower portion 32 when the basket device 3 is placed on the printed circuit board 1, as this is shown in Fig. 1. The via hole 100 extends, along a mounting direction M, through the dielectric body 10 of the printed circuit board 1, the body portion 31 reaching into the via hole 100 and having a conical cup shape circumferentially extending about the mounting direction M, as this is apparent when viewing Fig. 1 and Fig. 2 in combination.

The connector pin 2, by means of its shaft portion 21, is inserted into the basket device 3 such that the shaft portion 21 extends through an opening 320 formed in the lower portion 32 of the basket device 3. Whereas the head portion 20 comes to rest at a first side of the basket device 3 outside of the via hole 100, the shaft portion 21 reaches through the basket device 3 towards a second side of the basket device 3 and hence into the via hole 100.

Within the via hole 100 a solder connection 4 is formed in between the connector pin 2 and the basket device 3 such that the connector pin 2 is both mechanically and electrically connected to the basket device 3 and by means of the basket device 3 is retained on the printed circuit board 1 and is electrically connected to the conductive layer 11.

Referring now to Fig. 3, in one embodiment an electrically conductive coating 14 may be formed within the via hole 100 such that surrounding walls of the via hole 100 are coated by means of the electrically conductive coating 14. By means of the solder connection 4, hence, the connector pin 2 may be connected both to the basket device 3 and to the coating 14, which is electrically adjoins with the upper conductive layer 11 formed on top of the printed circuit board 1 and potentially also with one or multiple inner conductive layers 12, 13 formed within the dielectric body 10 of the printed circuit board 1.

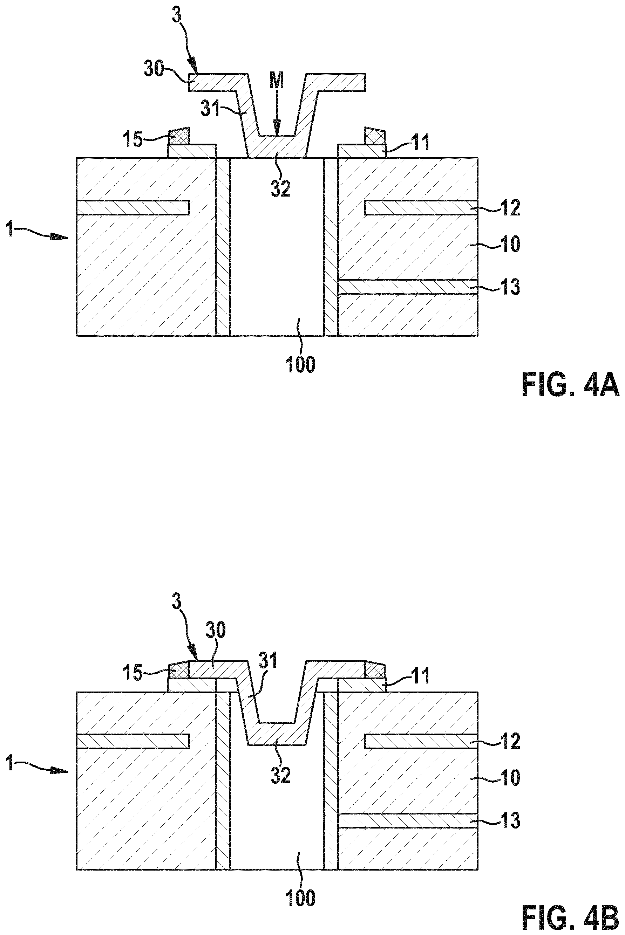

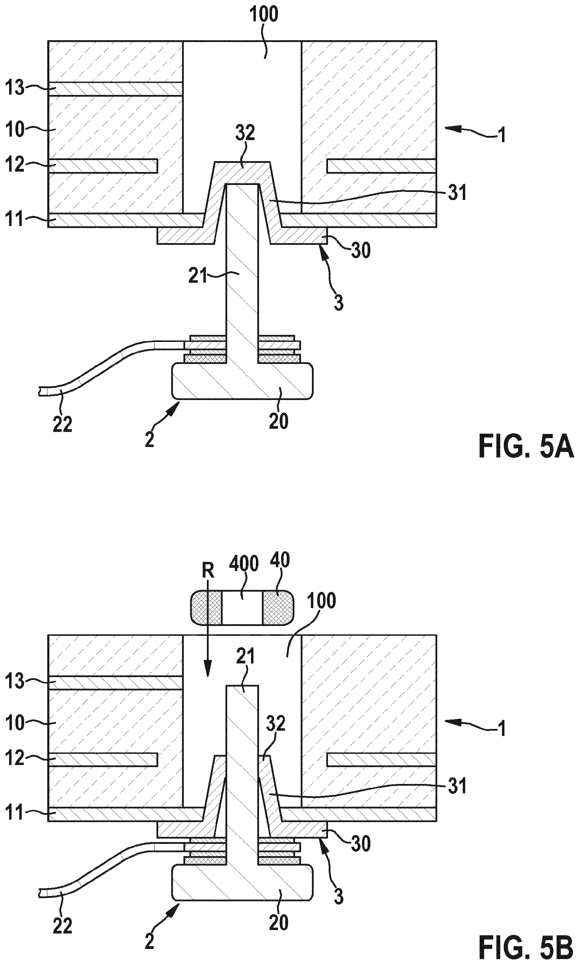

Figs. 4A to 4D and Figs. 5A to 5D show a process for establishing a connection in between a connector pin 2 and a printed circuit board 1.

In one embodiment, for establishing a connection in between the connector pin 2 and the printed circuit board 1, in a first step a basket device 3 is placed on the printed circuit board 1, as this is illustrated in Figs. 4A and 4B, such that the basket device 3 comes to rest, by means of the upper portion 30, on the conductive layer 11 formed on top of the dielectric body 10 of the printed circuit board 1. When placed on the printed circuit board 1 (Fig. 4B), the body portion 31 reaches into the via hole 100 formed within the dielectric body 10 of the printed circuit board 1, such that the lower portion 32 is placed within the via hole 100.

For mechanically fixing and electrically connecting the basket device 3 to the conductive layer 11 of the printed circuit board 1, in one embodiment a solder connection 15 is formed in between the basket device 3 and the conductive layer 11, for example by applying a suitable reflow soldering technique.

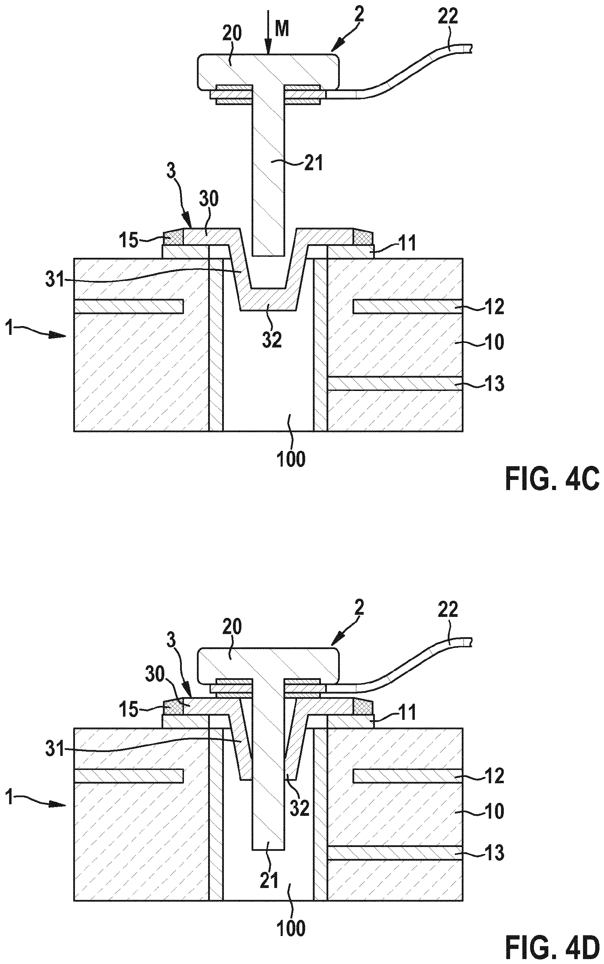

In a next step, as shown in Fig. 4C, the connector pin 2 is placed on the basket device 3 such that the shaft portion 21 of the connector pin 2 is inserted through the opening 320 formed in the lower portion 32 of the basket device 3. When placed on the basket device 3, as visible in Fig. 4D, the head portion 20 of the connector pin 2 comes to rest outside of the via hole 100, whereas the shaft portion 21 reaches through the lower portion 32 of the basket device 3 into the via hole 100 formed within the dielectric body 10 of the printed circuit board 1.

In the state of Fig. 4D the connector pin 2, by means of the basket device 3, is mechanically retained on the printed circuit board 1 and also is already electrically connected to the conductive layer 11 formed on the printed circuit board 1. The printed circuit board assembly may be functional in this state.

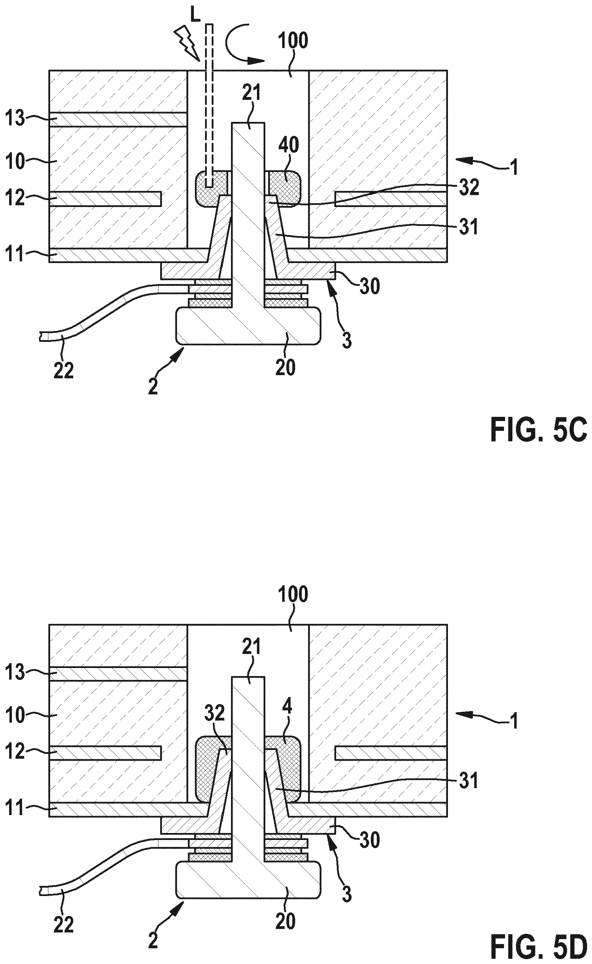

In one embodiment, however, the connection in between the connector pin 1 and the basket device 3 is further secured by forming a solder connection 4 in between the connector pin 1 and the basket device 3, as this is illustrated in Figs. 5A to 5D. After placing the connector pin 2 on the basket device 3 (Figs. 5A and 5B), a preform solder component 40 for example in the shape of a doughnut and having a central opening 400 is placed on the shaft portion 21 such that the preform solder component 40 comes to rest within the via hole 100 formed in the dielectric body 10 of the printed circuit board 1, as visible from Fig. 5C. By applying heat using a heat source, for example in the shape of a laser heat source L, the preform solder component 40 is melted to form the solder connection 4, as visible from Figs. 5C and 5D, such that the connector pin 2 is both mechanically and electrically fixed with respect to the basket device 3 and via the basket device 3 to the printed circuit board 11.

The placement of the connector device pin 2 on the basket device 3, as illustrated in Figs. 4A to 4D, may take place in a mounting direction M by inserting the connector pin 2 in the mounting direction M into the basket device 3 at the top of the printed circuit board 1. When placed on the basket device 3, as shown in Fig. 4D, the connector pin 2 is mechanically retained by means of the basket device 3 with respect to the printed circuit board 1.

This allows to flip over the printed circuit board 1 with the connector pin 2 arranged thereon, such that the connector pin 2 with its shaft portion 21 points upwards, as is visible from Fig. 5B. This allows to place the preform solder component 40 in a reverse direction R within the via hole 100 formed in the dielectric body 10 of the printed circuit board 1 and on the shaft portion 21 of the connector pin 2, as shown in Fig. 5C. The forming of the solder connection 4 hence may take place in a reverse direction R, at a back side of the printed circuit board 1 opposite the head portion 20 of the connector pin 2 and hence at a side remote from a component 22 connected to the connector pin 2.

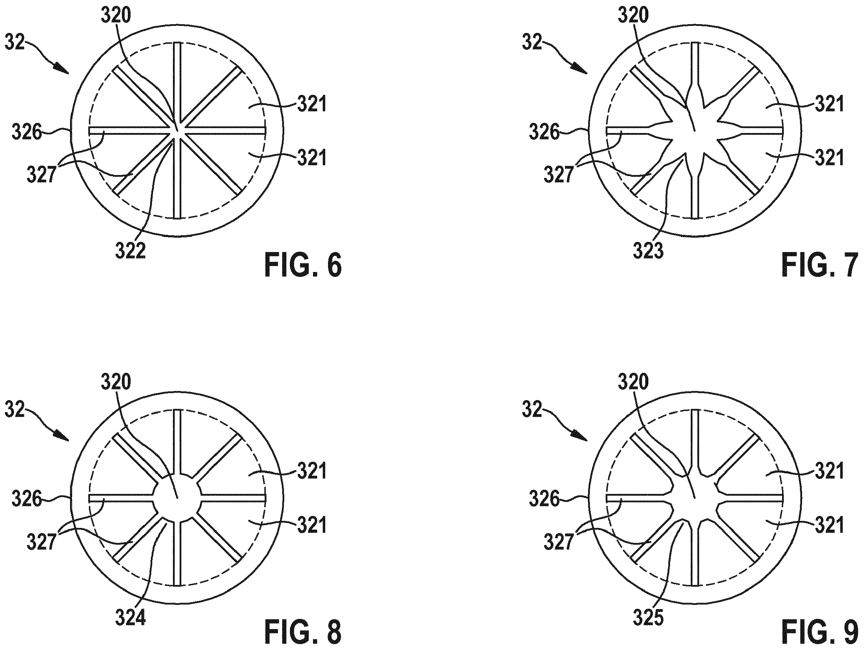

For retaining the connector pin 2 within the basket device 3, the lower portion 32 formed at the bottom of the cup-shaped body portion 31 of the basket device 3 may, in one embodiment, comprise a retaining structure serving to interact with the shaft portion 21 of the connector pin 2 when inserting the connector pin 2 into the basket device 3. Different examples of such retaining structure are shown in Figs. 6 to 9, the retaining structure being formed for example by a wedge pattern formed on the lower portion 32.

The wedge pattern, in the examples of Figs. 6 to 9, is formed by retaining elements 321 having the shape of wedges. The retaining elements 321 are connected to each other by means of a circumferential rim 326 and point towards an opening 320 centrally formed within the lower portion 32. Neighbouring retaining elements 321 herein are separated from each other (when viewed circumferentially about the mounting direction M) by slits 327 formed in between the respective neighbouring retaining elements 321, such that the retaining elements 321 are elastically deformable when inserting the connector pin 2 by means of its shaft portion 21 into the central opening 320 formed within the lower portion 32.

The examples of Figs. 6 to 9 differ in the shape of the retaining elements 321 in particular at their tips.

In the example of Fig. 6, the retaining elements 321 have pointed tips 322 pointing towards the central opening 320.

In the example of Fig. 7, the opening 320 has a star shape, each retaining element 321 at its tip 323 forming an angle which is larger than the wedge angle of the wedge-shaped retaining element 321 in a region remote from the tip 323.

In the example of Fig. 8, each retaining element 321 is cut-off at its tip 324, such that a blunt edge is formed in the region of each tip 324 for each retaining element 321.

In the example of Fig. 9, each retaining element 321 is rounded at its tip 325.

In each example, the retaining elements 21 are elastically deformable such that the connector pin 2 may be inserted into the respective central opening 320 under elastic deformation of the retaining elements 321. The retaining elements 321 hence act as springs for mechanically retaining the connector pin 2 in the basket device 3.

The retaining structure, as shown in different examples in Figs. 6 to 9, may for example be formed on the lower portion 32 of the basket device 3 by means of chemical milling using photolithography or by direct laser cutting.

The basket device 3 may be placed and fixed on the printed circuit board 1 by forming a solder connection 15 in between the basket device 3 and the conductive layer 11, as this is illustrated in Figs. 4A and 4B. Alternatively, the basket device 3 may be connected to the printed circuit board 1 by using a press-fit connection by pressing the basket device 3 into a suitable retaining structure formed on the printed circuit board 1.

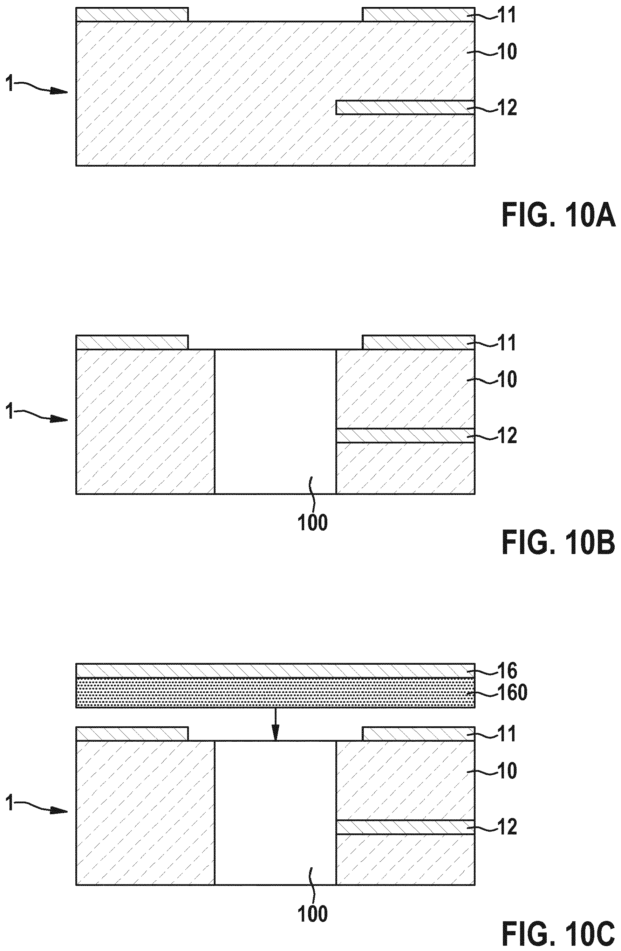

The forming of the printed circuit board 1, in one example, is illustrated in Figs. 10A to 10H.

Herein, in one example, a printed circuit board 1 may be provided, as illustrated in Fig. 10A, the printed circuit board 1 having multiple conductive layers 11, 12 formed on and within the dielectric body 10 of the printed circuit board 1.

As illustrated in Fig. 10B, a via hole 100 may be formed within the dielectric body 10 using for example a suitable drilling technique, for example a chemical drilling or a laser cut technique. The via hole 100 may, in one embodiment, extend through the entire dielectric body 10 and may touch a conductive layer 12 formed within the dielectric body 10.

A retaining structure for forming a press-fit connection with the basket device 3 may be formed by the conductive layer 11 using for example a chemical milling technique or a laser cut technique on the conductive layer 11 formed on top of the dielectric body 10 prior to or after forming the via hole 100 in the dielectric body 10.

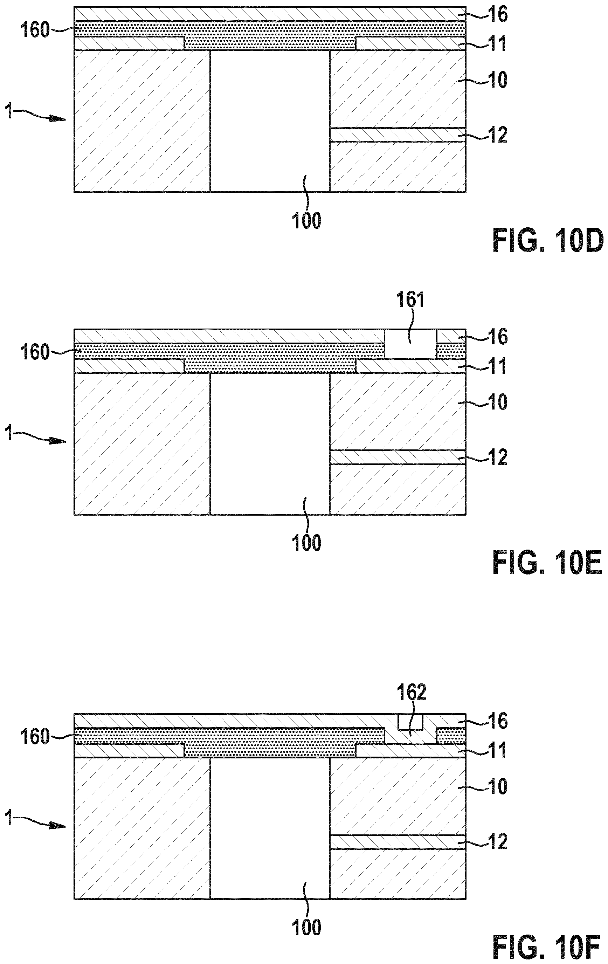

In an alternative approach, as illustrated in Figs. 10C to 10H, an additional conductive layer 16 may be placed on the printed circuit board 1 and may be fixed to the printed circuit board 1 by means of an adhesive layer 160 (Figs. 10C and 10D), such that the conductive layer 16 is joined to the printed circuit board 1 at the side of the conductive layer 11.

After placing the additional conductive layer 16 on the printed circuit board 1, a via connection is formed in between the conductive layer 16 and the conductive layer 11 beneath by forming a via 161 (Fig. 10E) and by forming an electrical connection 162 within the via 161 to electrically connect the conductive layers 11, 16 to each other (Fig. 10F).

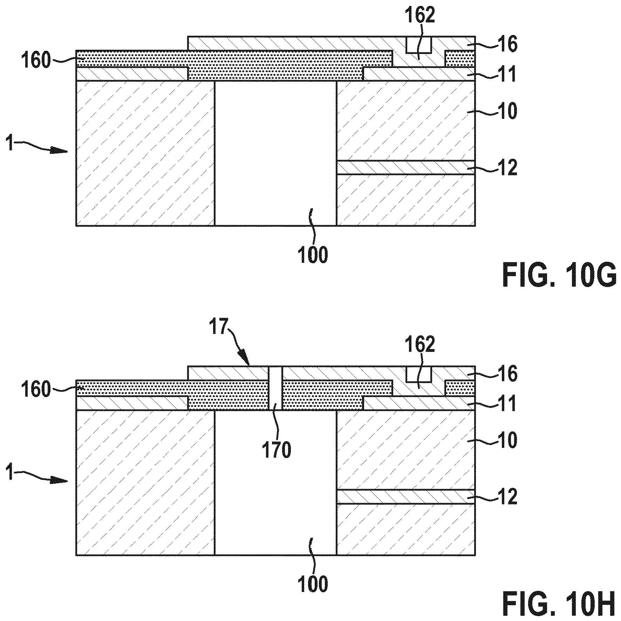

By applying a suitable chemical milling technique the conductive layer 16 (now forming the outermost layer of the printed circuit board 1) may be structured (Fig. 10G).

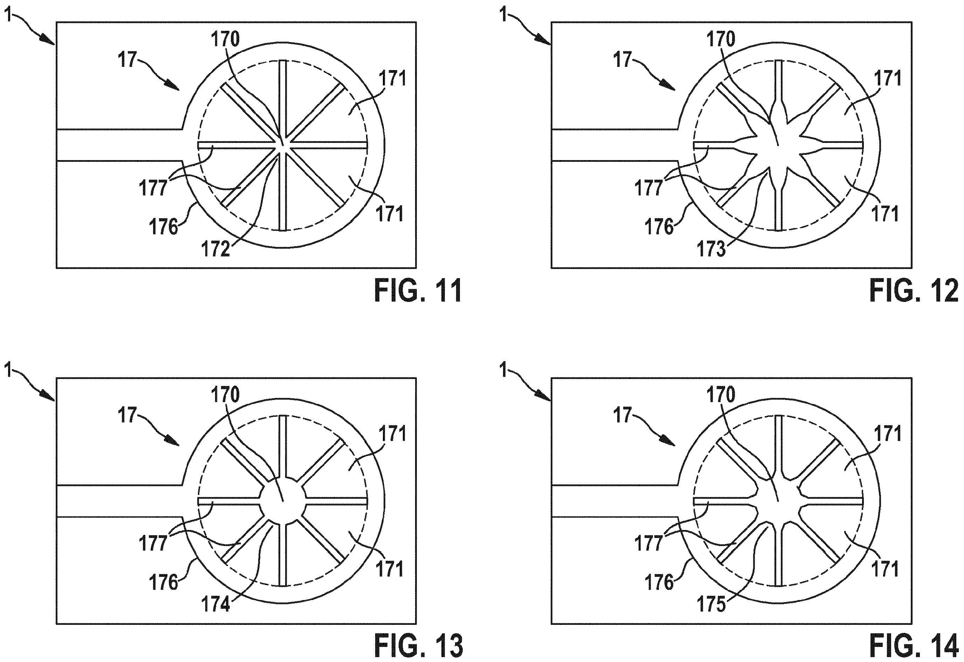

In addition, as illustrated in Fig. 10H, a retaining structure 17 may be formed within the conductive layer 16 and the adhesive layer 160 beneath, the retaining structure 17 having for example a structure as illustrated in different examples in Figs. 11 to 14.

The retaining structure 17 may be optionally formed within the conductive layer 16 (or in another embodiment directly in the conductive layer 11 formed on the dielectric body 10 of the printed circuit board 1) to connect the basket device 3 to the printed circuit board 1 in a force-fitting manner.

The retaining structure 17 herein may be shaped as it has been described above with reference to Figs. 6 to 9 for the lower portion 32 of the basket device 3 and may in particular comprise retaining elements 171 having a wedge shape and being separated from one another by means of slits 177 formed in between the retaining elements 171 such that the retaining elements 171 are flexibly deformable for retaining the basket device 3 on the printed circuit board 1. The retaining elements 171 are connected to each other by means of a circumferential outer rim 176, the retaining elements 171 extending from the rim 176 towards the inside and pointing with tips towards an opening 170 formed centrally within the retaining structure 17.

The examples of Figs. 11 to 14 differ, similarly as described above for Figs. 6 to 9, in the shaping of the retaining elements 171 at their tips. In particular, the retaining elements 171 may form pointed tips 172 (Fig. 11). In another example the retaining elements 171 may form a star-shaped opening 170 with tips 173 forming an angle larger than the wedge angle of the retaining elements 171 elsewhere (Fig. 12). In another example the retaining elements 171 may be cut-off at their tips 174 such that a blunt edge is formed in the region of the tips 174 (Figs. 13). In yet another example the retaining elements 171 may be rounded at their tips 175 (Fig. 14).

In each case the basket device 3 may be inserted into the opening 170 formed by the retaining structure 17 in order to force-fittingly connect the basket device 3 to the printed circuit board 1.

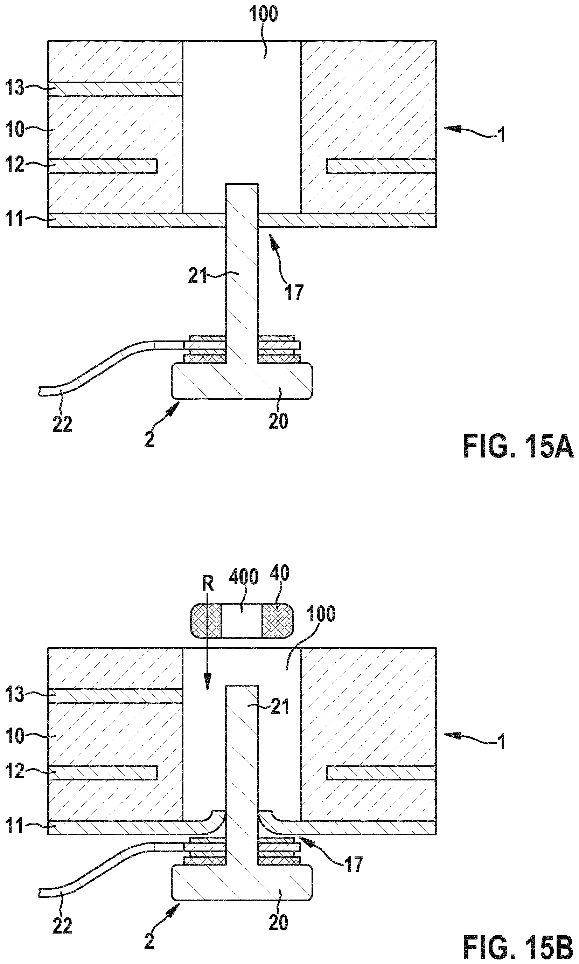

In an alternative approach a retaining structure 17 as illustrated in different examples in Figs. 11 to 14 may directly be used to retain a connector pin 2 on the printed circuit board 1, as this is illustrated in Figs. 15A to 15D, thus avoiding the use of a basket device 3.

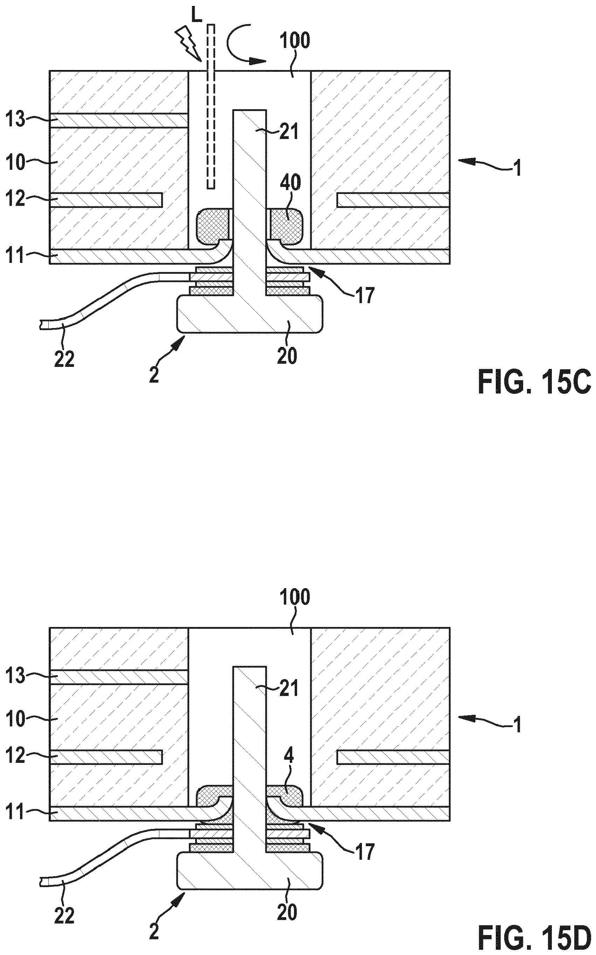

For connecting a connector pin 2 to the printed circuit board 1, in one embodiment, the connector pin 2 is inserted by means of its shaft portion 21 into the opening 170 formed by the retaining structure 17, causing a flexible, elastic deformation of the retaining elements 171 (Fig. 15A and 15B). The retaining structure 17 hence retains the connector pin 2 on the printed circuit board 1, such that the arrangement of the printed circuit board 1 and the connector pin 2 arranged thereon can for example be flipped over in order to place a preform solder component 40 having a doughnut shape within the via hole 100 and on the shaft portion 21 of the connector pin 2, as this is illustrated in Fig. 15B. The preform solder component 40 hence is arranged on the shaft portion 21 such that the shaft portion 21 extends through an opening 400 formed within the preform solder component 40, as shown in Fig. 15C.

By applying a suitable heat source, for example a laser heat source L (Fig. 15C), the preform solder component 40 is melted, thus forming a solder connection 4 in between the connector pin 2 and the conductive layer 11 forming, in the embodiment illustrated in Fig. 15A to 15D, the retaining structure 17 (Fig. 15D). The connector pin 2 thus is mechanically and electrically connected to the printed circuit board 1, such that a component 22 connected to the connector pin 2 is attached to the printed circuit board 1, as visible from Fig. 15D.

In all embodiments described above the connector pin 2 may for example have a superior electrical conductivity and may for example be gold-coated.

A method as described herein may in particular be used to place electrical or electronic component on a printed circuit board for use in the medical field, for example on medical devices such as implantable devices. However, a technique as described herein may also be used in other fields generally requiring the connection of components to a printed circuit board.

It will be apparent to those skilled in the art that numerous modifications and variations of the described examples and embodiments are possible in light of the above teaching. The disclosed examples and embodiments are presented for purposes of illustration only. Other alternate embodiments may include some or all of the features disclosed herein. Therefore, it is the intent to cover all such modifications and alternate embodiments as may come within the true scope of this invention.

### List of Reference Numerals

- 1: Printed circuit board (PCB)
- 10: Dielectric body
- 100: Via hole
- 11: Conductive layer
- 110: Conductor line
- 12, 13: Inner conductive layer
- 14: Conductive coating
- 15: Solder connection
- 16: Connective layer
- 160: Adhesive
- 161: Via
- 162: Electrical connection
- 17: Connection portion
- 170: Opening
- 171: Retaining elements
- 172: Pointed tips
- 173: Tips
- 174: Cut-off tips
- 175: Rounded tips
- 176: Rim
- 2: Connector pin
- 20: Head
- 21: Shaft portion
- 22: Component
- 23: Fastening connection
- 3: Basket device
- 30: Upper portion
- 31: Body portion
- 32: Lower portion
- 320: Opening
- 321: Retaining elements
- 322: Pointed tips
- 323: Tips
- 324: Cut-off tips
- 325: Rounded tips
- 326: Rim
- 327: Slits
- 4: Solder connection
- 40: Preform solder component
- 400: Opening
- L: Laser beam
- M: Mounting direction
- R: Reverse direction

## Claims

1. A method for connecting a connector pin (2) to a printed circuit board (1), the method comprising:
- providing a printed circuit board (1) having a dielectric body (10) and a conductive layer (11, 16), wherein a via hole (100) is formed in the dielectric body (10);
- placing a basket device (3) having a body portion (31) on the printed circuit board (10) such the basket device (3) electrically contacts the conductive layer (11, 16) and reaches, with said body portion (31), into the via hole (100) formed in the dielectric body (10) of the printed circuit board (1); and
- placing a connector pin (2) having a shaft portion (21) on the basket device (3) such that the shaft portion (21) reaches into said via hole (100) and the basket device (3) interacts with the connector pin (2) for retaining the connector pin (2) on the printed circuit board (1).

2. The method according to claim 1, wherein the placing of the basket device (3) on the printed circuit board (1) includes fixing the basket device (3) to the printed circuit board by means of a solder connection (15).

3. The method according to claim 1, comprising the additional step of fixing the connector pin (2) to the printed circuit board (1) by forming a solder connection (4) in the via hole (100).

4. The method according to claim 3, wherein the forming of the solder connection (4) includes placing a preform solder component (40) on the shaft portion (21) of the connector pin (2) and heating the preform solder component (40).

5. The method according to claim 1, wherein the body portion (31) has a cup shape circumferentially extending about a mounting direction (M) along which the body portion (31) reaches into the via hole (100) upon placement of the basket device (3) on the printed circuit board (1).

6. The method according to claim 1, wherein the basket device (3) comprises an upper portion (30) and a lower portion (32), the body portion (31) extending in between the upper portion (30) and the lower portion (32).

7. The method according to claim 6, wherein the placing of the basket device (3) on the printed circuit board (1) includes placing the upper portion (30) on said conductive layer (11, 16) such that the upper portion (30) electrically contacts said conductive layer (11, 16).

8. The method according to claim 6, wherein the lower portion (32) is shaped to mechanically retain the connector pin (2) with respect to the printed circuit board (1) upon placing the connector pin (2) on the basket device (3).

9. The method according to claim 8, wherein the lower portion (32) forms an opening (320), wherein the placing of the connector pin (2) on the basket device (3) includes inserting the shaft portion (21) of the pin connector (2) into the opening (320).

10. The method according to claim 9, wherein the lower portion (32) comprises a multiplicity of retaining elements (321) shaped to mechanically interact with the shaft portion (21) when inserting the shaft portion (21) into said opening (320) formed in the lower portion (32).

11. The method according to claim 10, wherein the retaining elements (321) each have a wedge shape and each comprise a tip (322-325) pointing towards said opening (320) formed in the lower portion (32).

12. The method according to claim 10, wherein neighboring retaining elements (321) are separated from each other by means of a slit (327) formed in the lower portion (32).

13. The method according to claim 9, wherein the connector pin (2) comprises a head portion (20) adjoining the shaft portion (21), wherein upon placing the connector pin (2) on the basket device (3) the head portion (20) comes to rest at a first side of the basket device (3), the shaft portion (21) extending from the first side through the opening (320) formed in the lower portion (32) towards a second side of the basket device (3).

14. The method according to claim 13, wherein a solder connection (4) for fixing the connector pin (2) to the printed circuit board (1) is formed on the second side of the basket device (3) after placing of the connector pin (2) on the basket device (3).

15. An printed circuit board assembly, comprising:
- a printed circuit board (1) having a dielectric body (10) and a conductive layer (11, 16), wherein a via hole (100) is formed in the dielectric body (10);
- a basket device (3) having a body portion (31), wherein the basket device (3) is placed on the printed circuit board (10) such the basket device (3) electrically contacts the conductive layer (11, 16) and reaches, with said body portion (31), into the via hole (100) formed in the dielectric body (10) of the printed circuit board; and
- a connector pin (2) having a shaft portion (21), wherein the connector pin (2) is placed on the basket device (3) such that the shaft portion (21) reaches into said via hole (100) and the basket device (3) interacts with the connector pin (2) for retaining the connector pin (2) on the printed circuit board (1).
